Europäisches Patentamt

European Patent Office

Office européen des brevets

(19)

(11) **EP 0 862 214 A1**

(12) **EUROPEAN PATENT APPLICATION**

(43) Date of publication:
02.09.1998 Bulletin 1998/36

(51) Int. Cl.$^6$: **H01L 23/522**

(21) Application number: 97200595.3

(22) Date of filing: 28.02.1997

(84) Designated Contracting States:
AT BE CH DE DK ES FI FR GB GR IE IT LI LU MC NL PT SE

(71) Applicant:
TELEFONAKTIEBOLAGET L M ERICSSON (publ)
126 25 Stockholm (SE)

(72) Inventors:
• van Roosmalen, Marcel Wilhelm Rudolf Martin
7558 CR Hengelo (NL)

• Verreck, Maurice
6524 SV Nijmegen (NL)

(74) Representative:
Dohmen, Johannes Maria Gerardus
Algemeen Octrooibureau,
P.O. Box 645
5600 AP Eindhoven (NL)

(54) **An integrated circuit having a planar inductor**

(57) An integrated circuit, comprising a spiral type inductor (16) having an outer winding (7) and an inner winding (8) formed on a substrate (1). The outer winding (7) comprises an external circuit terminal (17), that is a circuit terminal not surrounded by the outer winding (7), and the inner winding (8) comprises an internal circuit terminal (18) surrounded by the inner winding (8). Circuit elements (20) are located at part (19) of the substrate (1) enclosed by the inner winding (8). The circuit elements (20) operatively connect to the internal circuit terminal (18), such to form a Radio Frequency (RF) integrated circuit device.

Fig. 4

EP 0 862 214 A1

## Description

Field of the Invention

The present invention relates generally to integrated circuits and, more specifically, to integrated circuits comprising a planar inductor formed with a substrate.

Background of the Invention

Planar inductors are two-terminal devices consisting of a number of conductive windings or turns bounded by an outer winding and an inner winding and are generally formed with a substrate, such as the substrate of an integrated circuit. In general, planar inductors are designed having a circular, rectangular or other spiral shape, for example.

Planar inductors of this type are known in the art of integrated circuit design, such as disclosed by US-A-5,396,101.

The prior art planar inductors are provided with external circuit terminals, that is a first terminal connecting to the end of the outer winding of the inductor and a second external terminal connecting, by a conductive bridging layer, to the end of the inner winding. This bridging layer crosses the windings of the inductor. The term "external" refers to a position at the substrate not surrounded by the outer winding of the inductor.

The bridging layer adversely affects the maximum achievable Q-value of the inductor, because it adds resistance to the inductor. Further, the bridging layer does not contribute to the mutual inductance between the windings of the inductor because the bridging layer is perpendicular to the windings of the inductor. Further, due to the crossing of the bridging layer and the windings, additional parasitic capacitance is introduced which, in particular at high frequencies, reduces the inductive properties of the inductor.

Due to their 3-dimensional nature, prior art inductors are difficult to model in Integrated Circuit (IC) design, for which it is important to have simple and reliable models.

Summary of the Invention

The present invention has for its object to provide an integrated circuit having an improved spiral type inductor deployment.

It is a further object of the present invention to provide an integrated circuit having a planar spiral inductor providing an efficient as possible usage of the available substrate area.

According to the present invention, there is provided an integrated circuit, comprising a spiral type inductor having an outer winding and an inner winding formed with a substrate. The outer winding comprises an external circuit terminal, whereas the inner winding comprises an internal circuit terminal surrounded by the inner winding.

By the position, according to the invention, of one circuit terminal of the inductor external to the outer winding, i.e. not surrounded by a winding of the inductor, and another circuit terminal at the area of the substrate surrounded by the inner winding, the need for a bridging layer or bridging track is avoided. Thereby eliminating its resistance and the capacitive cross coupling between such bridging track and the windings of the inductor. This effectively resulting in a higher so-called quality (Q)-factor. The Q-factor is the ratio between the amount of magnetic energy stored in the inductor and the power dissipated. A high Q-value is in most practical cases desired.

In a further embodiment of the invention, the surface area of the substrate enclosed by the inner winding of the inductor is provided with circuit elements, connecting to the internal circuit terminal of the inductor. The circuit elements comprise at least part of circuitry connecting to the inductor.

Besides the advantage of an improved Q-factor, the positioning of the circuit elements at the region of the substrate enclosed by the inner winding of the inductor provides a very efficient usage of scarce substrate area. As a reference, the dimensions of spiral inductors typically are in the range of 100-300 microns. In terms of IC-design, such spiral inductors occupy a relatively large substrate area. Leaving the region enclosed by the inner winding unused is thus very unfavourable in terms of costs and yield of the IC manufacturing.

In a yet further embodiment of the invention, the circuit elements positioned within the region of the substrate enclosed by the inductor are preferably of a type not vulnerable to electromagnetic radiation. This, in view of the presence of a magnetic field in this area, which magnetic field in this region is stronger than in the region external to the inductor.

The above magnetic field will be stronger closer to the windings. Accordingly, in another embodiment of the invention, conducting leads of circuit elements within the region enclosed by the inductors are positioned substantially transverse to the adjacent inner winding. This to avoid as much as possible induction currents induced in such leads by the magnetic field of the inductor.

According to the invention, the inductor windings can be positioned with a wider diameter, if required, without wasting scarce substrate area.

The inductor according to the present invention can be applied in all available silicon and gallium arsenide (GaAs) technologies supporting the use of planar inductors. On semiconductor foundries with one metal layer only and a polysilicon interconnect layer, the inductor according to the invention appears to be the only reasonable solution to obtain acceptable Q-values. This, due to the relative high resistance of the polysilicon interconnect layer which negatively affects the value of the Q-factor.

The circuit elements placed within the region enclosed by the inductor can be any type of semiconductor device, such as a transistor formed in a substrate, a resistor or a capacitor formed on the substrate. In the case of circuit elements which are vulnerable to electromagnetic radiation, such circuit elements may still be placed in the exterior region of the inductor. However, by connecting the inductor directly to an active element positioned within its interior region, the advantages of the improved deployment of the connecting internal terminal of the inductor according to the invention are still reached.

The above-mentioned and other features and advantages of the invention are illustrated in the following description with reference to the enclosed drawings.

Brief Description of the Drawings

Figure 1 schematically shows a plan view of a prior art inductor and connecting circuitry.

Figure 2 shows, not to scale, a perspective cross-section view along section line II-II of part of the inductor of figure 1.

Figure 3 schematically shows a plan view of an inductor according to the present invention.

Figure 4 schematically shows a plan view of an inductor and connecting circuitry according to the present invention.

Figure 5 shows the inductor and circuitry according to figure 4 connecting to other circuity on a substrate.

Figure 6 schematically shows a plan view of an inductor according to the present invention formed from several separate interconnected elements.

Figure 7 is a schematic top view of an integrated circuit comprising the inductor according to the invention, wherein part of the package is shown partly broken away.

Detailed Description of the Embodiments

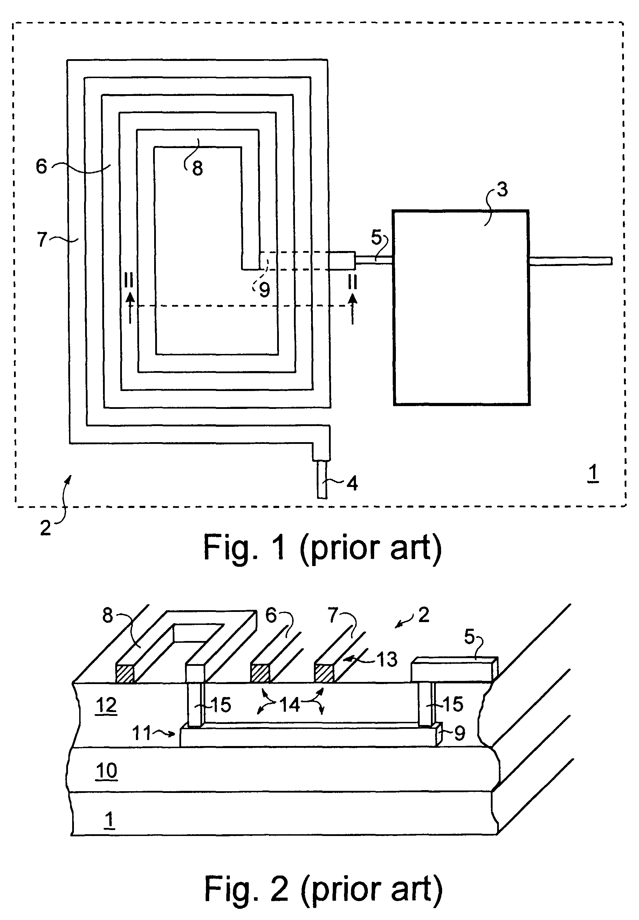

Figure 1 shows a plan view of a typical prior art planar inductor 2 on a substrate 1 and connecting circuitry 3. For illustrative purposes, the circuitry 3 are shown in the form of a block. In practice, the circuit elements making up the circuitry 3 are formed in or at the substrate 1 according to known Integrated Circuit (IC) design technology.

The inductor 2 has a two-dimensional (planar) structure having a number of windings 6 wound in the form of a spiral bounded by an outer winding 7 and an inner winding 8.

An end of the outer winding 7 forms a first circuit terminal 4 and an end of the inner winding 8 forms a second circuit terminal 5. De first and second circuit terminals 4, 5 are located external to the inductor 2 and are coupled to the circuitry 3 external of the inductor 2, i.e. not surrounded by the windings of the inductor 2.

As can be seen from figure 1, part 9 of the inner winding 8 forms a bridging layer or bridging track between the second circuit terminal 5 and the inner winding 8. The bridge 9 extends transverse to the windings 6, 7 of the inductor 2 and hence contributes not to the mutual inductance of the inductor 2.

Figure 2 shows an enlarged cross-sectional view along section line II-II of figure 1. The semiconductor substrate 1 is comprised of, for example, gallium arsenide (GaAs), silicon, germanium or the like. An optional layer of field oxide 10 is formed on the semiconductor substrate 1, using techniques which are itself known in the art. A first layer of conductive material 11 is formed on the layer of field oxide 10. Parallel to the metal layer 11 another metal layer 13 is formed. The metal layers 11 and 13 are separated by an intermediate layer 12 of electrically insulating material.

The metal layer 13 is patterned to form the windings 6, 7, 8 of the inductor 2. The metal layer 11 provides the bridging layer or bridging track 9 for connecting the end of the inner winding 8 through vias 15 to the circuit terminal 5. As can be seen from figure 2, the bridge 9 forms capacitors 14 with the windings 6, 7, 8. The metal layer 11 may serve as a general connecting layer for other elements in the substrate and may not be dimensioned in view of low resistance.

A widely used figure of merit for (planar) inductors is the quality (Q)-factor of the inductor, which is related to the inductors impedance as:

$$Q = \frac{Im(Z)}{Re(Z)}$$

wherein: $Q$ = quality factor,
$Z$ = complex impedance of the inductor,
$Im(Z)$ = imaginary part of $Z$, and
$Re(Z)$ = real part of $Z$.

A high Q-value is achieved by a spiral inductor, which shape provides the best mutual coupling between the windings of planar inductors formed in or on a substrate.

The Q-value is inversely proportional to the Direct Current (DC) resistance of the inductor. i.e. $Re(Z)$. The bridge 9 does not contribute to the mutual inductance of the inductor 2, i.e. $Im(Z)$, but merely to the DC resistance, which may be high in case of a layer 11 having a high square resistance, and its capacitive action 14 limits the inductive action of the inductor 2. Accordingly, the bridge 9 reduces the Q-value of the inductor 2.

In stead of forming the bridge 9 as a so-called under pass of the windings 6, 7, 8, as shown in figure 2, it is also possible to form the bridge 9 as a so-called over pass, wherein the bridge 9 is formed in the upper metal layer 13 and the windings 6, 7, 8 are formed in the lower metal layer 11, for example. In both cases, this results in a three-dimensional structure, which is difficult to model for IC-design. For modern computer controlled IC-design, simple and reliable calculation models are required.

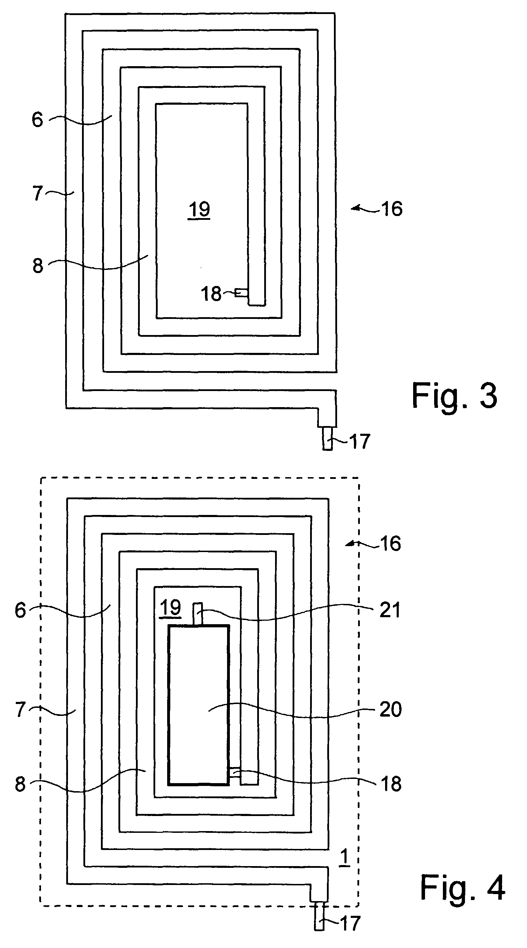

Figure 3 shows a plan view of an improved planar inductor 16 according to the present invention, having windings 6, 7, 8 positioned to form a planar spiral inductor.

An end of the outer winding 7 connects to an external circuit terminal 17, i.e. external to the outer winding 7 of the inductor 16, and an end of the inner winding 8 connects to an internal circuit terminal 18 according to the present invention.

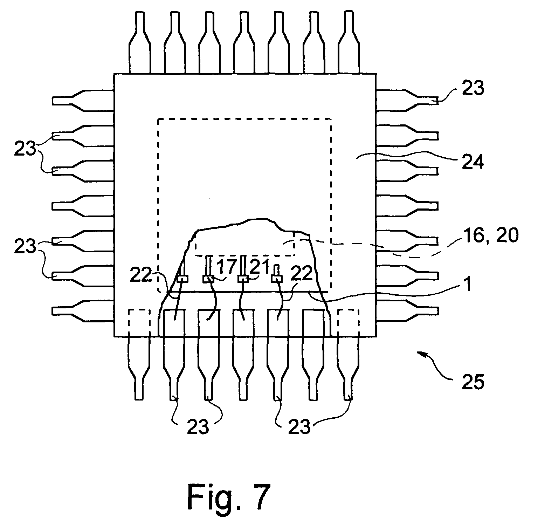

The internal circuit terminal 18 is positioned in the region 19 surrounded by the inner winding 8 of the inductor 16. As shown in figure 4, in accordance with the present invention, circuitry 20 is disposed in the region 19 of the inductor 16 and connects to its internal circuit terminal 18 thereby avoiding the need for a bridging layer or bridging track, according to the above-mentioned prior art design. The circuit terminal 17 and output/input terminals 21 of the circuitry 20 can be connected in an known manner via bonding wires 22 to contact strips 23 for surface mount (or to contact pins for through hole connection) extending from a plastic package 24 which encapsulates the integrated circuit substrate 1 with its inductor 16 and circuitry 20, forming an integrated circuit 25 according to the present invention as shown in figure 7.

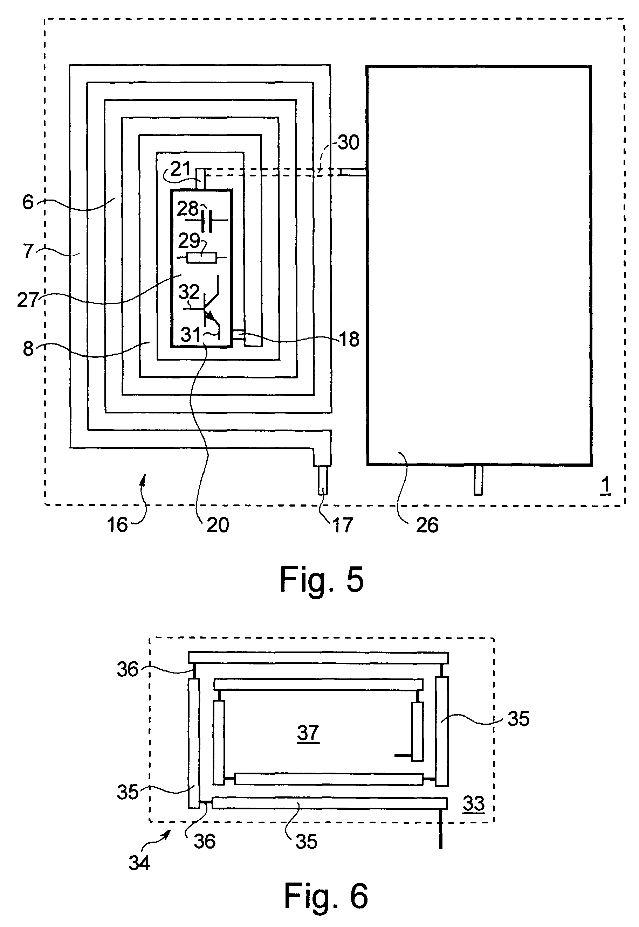

With the positioning of the circuitry 20 in the region 19 surrounded by the inner winding 8 of the inductor 16, a very efficient use of the available substrate area of the IC 25 is achieved. In practical designs, the region 19 typically amounts 100-300 microns, which, in terms of IC-design technology, is a very large area. The circuit elements provided at the inner region 19 of the inductor 16 are preferably circuit elements not vulnerable to electromagnetic fields or radiation. In the case of circuit elements the functioning of which suffers from electromagnetic field influences, such circuitry can still be positioned at the substrate area external to the inductor 16, as shown in figure 5. The block 26 denotes the circuit elements external to the inductor 16.

As schematically indicated in fig. 5, the circuit elements may comprise transistors 27, capacitors 28 and resistors 29, for example. In order to avoid as much as possible any induction currents in conducting leads of the circuitry 20, such as leads 31 and 32 for the connection of the transistor 27, for example, these leads are positioned as much as possible transverse to the adjacent windings, such as shown. Lead 31 is transverse to the lower part of inner winding 8, whereas lead 32 is transverse to the left part of winding 8, viewed from the position shown in figure 6.

Although the solution according to figure 5 is not optimal due to the capacitive coupling between the windings 6, 7, 8 and the connecting bridge 30 between the circuitry 20 and 26, the advantage of reduced DC resistance of the total inductor 16 by avoiding the bridge 9, and hence an improved Q-value, still exists.

The planar inductor according to the present invention can be formed from a single metal layer or multiple metal layers and a polysilicon interconnect layer for the bridge 30, for example.

Figure 6 shows an inductor 34 formed with a semiconductor substrate 33 and consisting of a plurality of strip type elements 35 formed from a single metal layer disposed on the substrate 33. The elements 35 are connected by interconnecting pieces 36, as shown.

If required, the elements 35 or in general the windings 6, 7, 8 of the inductor 16 may be positioned with relatively wide diameter without loss of usable substrate area by forming circuit elements within the internal region 37 of the planar inductor 34 according to the present invention. The metal layer or metal layers may be of aluminum, titanium, silver, tungsten, gold, etc. In general, any conductive material is possible, however for obtaining a high Q-value the conductive layer has to posses a low as possible DC resistance.

As those skilled in the art will appreciate, the spiral inductor may be formed with any shape, such as a rectangular, circular, elliptical or a polygonal shaped planar spiral inductor. Further, several planar inductors may be arranged oppositely on top of eachother and appropriately connected, to increase the total inductance, i.e. the Q-value and to decrease the total DC resistance by parallel connection, such as disclosed by US-A-5,446,311.

An integrated circuit according to the present invention can be used interalia in Radio Frequency (RF) filter circuits and transceiver circuitry for use in transceivers for radio communication, such as cordless or mobile radio equipment operating in accordance with the Digital Enhanced Cordless Telecommunications (DECT) or the Global System for Mobile communications (GSM) standards, for example.

**Claims**

1. An integrated circuit, comprising a spiral type inductor having an outer winding and an inner winding formed on a substrate, said outer winding comprising an external circuit terminal, characterized in that said inner winding comprises an internal circuit terminal surrounded by said inner winding.

2. An integrated circuit according to claim 1, comprising at least one circuit element, the or each circuit elements being located at part of the substrate enclosed by said inner winding and operatively connect to said internal circuit terminal.

3. An integrated circuit according to claim 2, wherein the or each circuit element is a circuit element not vulnerable to electromagnetic radiation.

4. An integrated circuit according to claim 2 or 3, wherein the or each circuit element is a semiconductor device, such as a transistor, formed in said substrate.

5. An integrated circuit according to claim 2 or 3, wherein the or each circuit element is a passive electrical component, such as a resistor and capacitor, formed in said substrate.

6. An integrated circuit according to claim 2, 3, 4 or 5, wherein conducting leads of the or each circuit element are substantially transverse to adjacent parts of said inner winding.

7. An integrated circuit according to any of the previous claims, wherein windings of said conductor are formed from separate segments in a metal layer.

8. An integrated circuit according to claim 7, wherein said metal layer is of aluminum, titanium, silver, tungsten, gold or the like.

9. An integrated circuit comprising at least one inductor and at least one circuit element according to any of the previous claims forming a Radio Frequency (RF) integrated circuit device.

## Fig. 1 (prior art)

## Fig. 2 (prior art)

Fig. 3

Fig. 4

Fig. 5

Fig. 6

Fig. 7

European Patent
Office

**EUROPEAN SEARCH REPORT**

Application Number

EP 97 20 0595

## DOCUMENTS CONSIDERED TO BE RELEVANT

| Category | Citation of document with indication, where appropriate, of relevant passages | Relevant to claim | CLASSIFICATION OF THE APPLICATION (Int.Cl.6) |
|---|---|---|---|
| X | PATENT ABSTRACTS OF JAPAN vol. 009, no. 039 (E-297), 19 February 1985 & JP 59 181046 A (TOSHIBA KK), 15 October 1984, * abstract * --- | 1-5,9 | H01L23/522 |
| X | WO 96 42110 A (NIIGATA SEIMITSU CO LTD ;IKEDA TAKESHI (JP); NAKANISHI TSUTOMU (JP) 27 December 1996 * abstract; figures * ----- | 1-5,9 | |
| | | | TECHNICAL FIELDS SEARCHED (Int.Cl.6) H01F H01L |

The present search report has been drawn up for all claims

| Place of search | Date of completion of the search | Examiner |
|---|---|---|
| THE HAGUE | 30 July 1997 | Marti Almeda, R |

CATEGORY OF CITED DOCUMENTS

X : particularly relevant if taken alone
Y : particularly relevant if combined with another
      document of the same category
A : technological background
O : non-written disclosure
P : intermediate document

T : theory or principle underlying the invention
E : earlier patent document, but published on, or
      after the filing date
D : document cited in the application
L : document cited for other reasons

& : member of the same patent family, corresponding
      document

EPO FORM 1503 03.82 (P04C01)